# EUROPEAN PATENT APPLICATION

(11) **EP 0 666 500 A1**
(43) Date of publication of application: **09.08.1995**
(21) Application number: 94200274.2
(22) Date of filing: 02.02.1994
(51) Int. Cl.: G03C 1/83, G03F 5/00, H04N 1/405

(54) **Photographic material for frequency modulation screening**

(71) Applicant: AGFA-GEVAERT naamloze vennootschap, B-2640 Mortsel (BE)
(72) Inventor: Claes, Roland, Septestraat 27, B-2640 Mortsel (BE); De Voeght, Frank, Septestraat 27, B-2640 Mortsel (BE)

(57) **Abstract**

A frequeny modulated halftone image can be obtained with excellent quality when the screened data are recorded onto a photographic material comprising a sublayer containing a dye absorptive for the laser or light-emitting diode radiation used for the exposure.

## Description

### 1. Field of the invention.

The present invention relates to the formation of a halftone image, generated from a frequency modulated screen pattern original, with improved sharpness.

### 2. Background of the invention.

In graphic arts reproduction processes the original image appearing to have a continuous tone gradation is reproduced by a collection of a large number of dots and/or lines. The tone of the reproduced image is influenced by both the size of the dots and lines and their density. The technique by which each particular area of a continuous tone original is broken up into a large number of small dots is called screening.

In a commonly used halftone screening technique, the continuously changing tone values of the original are modulated with periodically changing tone values of a superimposed two-dimensional screen. The modulated tone values are then subject to a thresholding process wherein tone values above the treshold value will be reproduced and those below will not be reproduced. The process of tone-value modulation and thresholding results in a two-dimensional arrangement of equally spaced "screen dots" whose dimensions are proportional to the tone value of the original at that particular location. The number of screen dots per unit distance determines the screen frequency or screen ruling. This screening technique wherein the screen frequency is constant and inversely proportional to the halftone elementary cell size is referred to as amplitude-modulation screening or autotypical screening. This technique can be implemented photo-mechanically or electronically.

The photo-mechanical implementation involves an analog process wherein a screen of equally spaced dots is physically superimposed, in contact or in projection with the original. Screen dots are formed when this combination is photographically reproduced in a system wherein thresholding is achieved through the use of special photographic films and developing chemicals producing a very high photographic contrast resulting in a sharp distinction between tone values above and below a certain level.

The electronic implementation of autotypical screening is a digital process whereby the continuous tone values of the original are broken up into discrete tone-value levels, specified at discrete areal coordinates within the original image. Each tone value is compared with an electronic threshold level, and values above the threshold are reproduced while those below the threshold are not. Screen dots are formed when a specific pattern of threshold values is defined in a two-dimensional array corresponding to the size of a halftone cell, and this threshold pattern is periodically applied across the image.

It will further be clear that in order to reproduce a color image using lithographic printing it will be required to separated the image in three or more part-images corresponding to primary colors that when printed over each other yield the desired color at any place within the image. Each of these colour separations has to be screened as described above.

When using conventional amplitude modulation halftoning some unwanted artifacts can occur in the reproduced photographic image and hence also in the final print for which the photographic film serves as intermediate. When the original contains high spatial frequencies the original subject pattern can seem to have disappeared. Instead a new pattern has emerged with a frequency that is lower than the frequency of the subject pattern, and that masks the latter. This effect is called subject Moiré, since it originates from the geometric interaction between the halftone screen and the original subject. It is subject Moiré which effectively limits the proper rendition of subject detail containing spatial frequencies higher than half the frequency of a conventional halftone screen. So subject Moiré can be avoided by using a halftone screen with sufficiently high frequency.

Another problem with conventional halftoning arises from geometric interactions between the halftones of the different colour separations in multicolour printing. The traditional solution for this so-called colour Moiré consists in rotating the different colour selections 60 degrees relative to each other. But even in this case, however, a micro Moiré, called "rosette" remains present with a period almost 7.5 times larger than the period of the screen itself.

Subject Moiré, colour Moiré and rosette patterns can be avoided by using an alternative technique, called frequency modulation screening.

Frequency modulation screening, also called stochastic screening, is a technique in which the continuously changing tone values of an original are reproduced by means of equally sized micro dots, the number of which, not the size, is proportional to the tone value of the original image. The name frequency modulation refers to the fact that the number of micro dots per unit surface (the frequency) fluctuates in relation to the tone value in the corresponding area of the original. This technique puts high demands on the laser apparatus which writes the micro dots and to the photographic material which records them. The apparatus must be able to write spots in the order of 10 à 20 microns. The photographic material must be able to reproduce these fine spots in a sharp way. In practice it means that the dots must be rendered in the right dimension and have a high density over the full tone scale. So it is clear that this technique puts high requirements to the sharpness characteristics of the photographic material. Unless special design measures are taken a conventional image-setting film will not be able to comply with these high demands.

It is the object of the present invention to provide a method for the formation of a halftone image using a frequency modulation technique permitting a sufficienly sharp rendering of micro dots generated by exposure of the screened data.

### 3. Summary of the invention.

The object of the present invention is realized by providing a method for the formation of a halftone image, said method comprising the steps of screening an original by a frequency modulation screening technique, recording the obtained screened data by means of a laser or a light-emitting diode on a photographic material comprising a support and at least one silver halide emulsion layer, and developing said exposed photographic material, characterized in that said photographic material further comprises a non-light sensitive sublayer which is positioned between said support and said at least one emulsion layer, and which contains a dye absorptive for the radiation of said laser or light-emitting diode.

In a preferred embodiment this dye is a non-diffusable dye under conventional coating conditions.

Preferably the frequency modulated screening technique used is the CristalRaster (registered trade mark) technology, marketed by AGFA.

### 4. Detailed description of the invention.

A suitable frequency modulation screening technique for use in connection with the present invention is the well-known error diffusion technique first described by Floyd and Steinberg in "An adaptive algorithm for spatial grey scale" SID 75 Digest. Society for information display 1975, pp. 36-37. According to the error diffusion technique the image pixels of a continuous tone image are processed one after the other according to a predetermined path e.g. from left to right and top to bottom.

The tone value of each image pixel is thereby compared with a threshold value which is generally the tone value half-way the tone scale e.g. 128 when the tones of the image-pixels range from 0 to 256. Depending on whether the tone value of the image pixel is above or below the threshold value a halftone dot will be set or not in the corresponding reproduction of the image pixel. The resulting error or weighted error, i.e. the difference between the reproduction value and actual value of the image pixel, is then added to the tone value of one or more neighbouring image pixels that are still unprocessed. Details about the error diffusion screening method may be found in the aforementioned reference or in US-P-5,175,804.

A more preferred variant of frequency modulation screening for use in connection with the present invention is a method similar to the error diffusion with the exception that the order in which the image pixels are processed can be described by a space filling deterministic fractal curve or a randomized space filling curve.

This type of frequency modulation screening comprises the following steps:
- selecting an unprocessed image pixel according to a space filling deterministic fractal curve or a randomized space filling curve and processing said unprocessed image pixel as follows:
- determining from the tone value of said unprocessed image pixel a reproduction value to be used for recording said image pixel on a recording medium e.g. a photographic film or lithographic printing plate precursor,
- calculating an error value on the basis of the difference between said tone value of said unprocessed image pixel and said reproduction value, said unprocessed image pixel thereby becoming a processed image pixel,
- adding said error value to the tone value of an unprocessed image pixel and replacing said tone value with the resulting sum or alternatively distributing said error value over two or more unprocessed image pixels by replacing the tone value of each of said unprocessed image pixels to which said error value will be distributed by the sum of the tone value of the unprocessed image pixel and part of said error,
- repeating the above steps until all image pixels are processed.

The above desribed preferred frequency modulation technique is implemented in the so-called CristalRaster technology (registered trade mark) marketed by Agfa.

A suitable deterministic fractal curve is for example the so called "Hilbert Curve" disclosed by Witten Ian H., and Radford M. Neal, "Using Peano Curves for Bilevel Display of Continuous-Tone Images", IEEE CG&A, May 1982, pp. 47-52.

According to the most preferred embodiment of the present invention the order of processing the image pixels is ruled by a randomized space filling curve. With the term "randomized space filling curve" is meant that the processing of the image pixels follows basically a pre-determined curve that assures that each image pixel will be processed but which curve is randomized at a number of points so that patterns are avoided.

Such randomized space filling curve can be obtained in different ways. For example the Hilbert Curve may be used as the pre-determined curve on which randomization is performed, e.g. by a computer program.

According to an alternative a randomized space filling curve may be obtained by dividing the image into matrices of image pixels. Within each of these matrices the image pixels are processed at random until all image pixels are processed. The order in which the matrices are processed may then be selected at random or in a predetermined way. A further alternative to the above method of dividing the image into matrices is the recursively division of the image into smaller matrices until the size of a matrix reaches an image pixel. At every subdivision into smaller submatrices a random ordering of processing the matrices is assigned to every submatrix. A computer program can be used to carry out this process.

More details on the above explained preferred frequency modulation technology can be found in the European Patent Applications Appl. No's 93201113, 93201114 and 93201115. As alternatives for Agfa's CrystalRaster technology the so-called "Diamond Screening" technology marketed by Linotype-Hell Co or the so-called "Mezzodot" technique marketed by Berthold AG can be used in the practice of the present invention.

The sublayer incorporated in the photographic material in accordance with the present invention is positioned between the support and the emulsion layer(s). The dye incorporated in this sublayer is preferably a non-diffusible dye. By this is meant non-diffusible under normal coating conditons the pH of the coating solution being neutral or slightly acid depending on the isoelectric point of the gelatin used and the chemical nature of the dye. Under alkaline processing conditions the dye may become diffusable and/or may discolour. Non-diffusable dyes are described in e.g. GB 1.563.809, EP 0 015 601, and a survey can be found in Unexamined Japanese Patent Publications (Kokai) 03-24539, 03-4223, 02-9350, 02-282240 and 03-1133. New classes are recently disclosed in European Patent Applications Appl. No's 92202465, 92202468 and 92202767. Useful actual compounds include following formulas :

### - merostyryl dyes

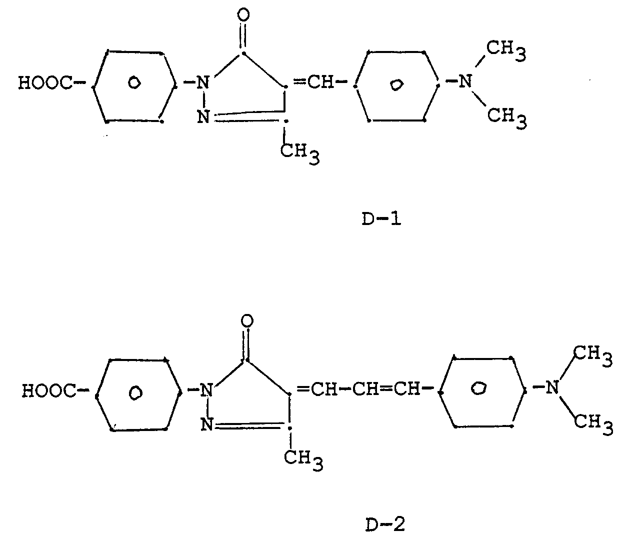

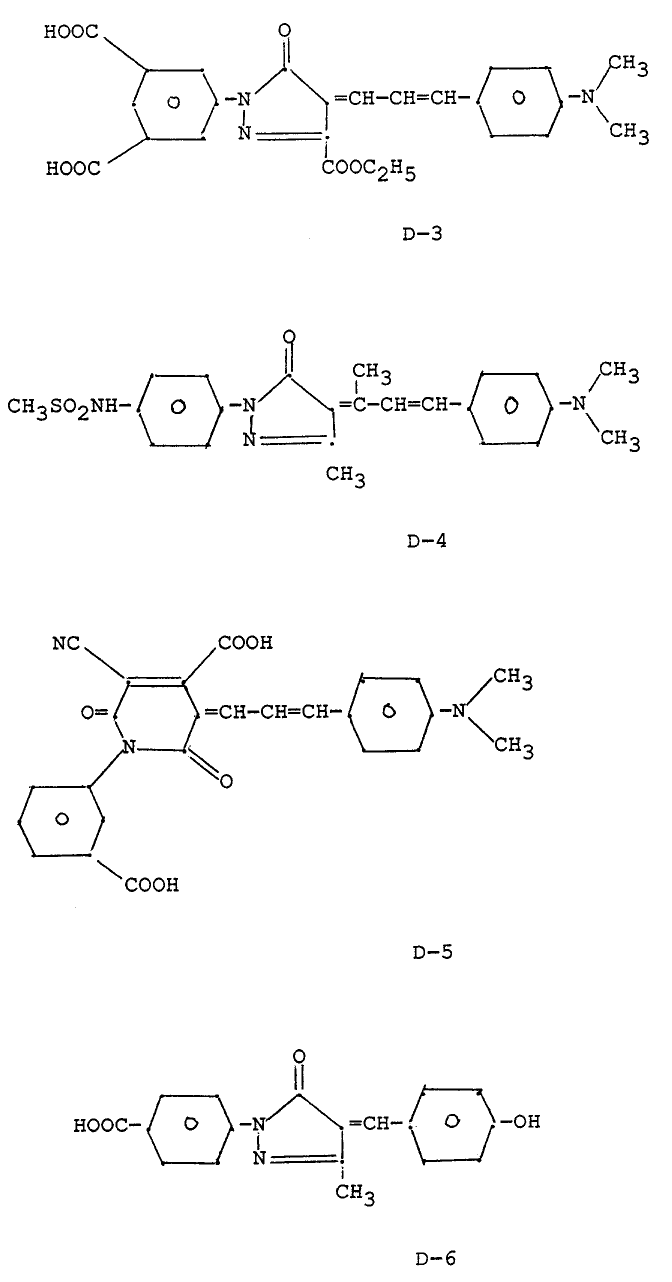

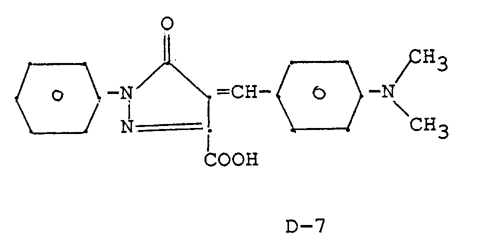

### - oxonol dyes

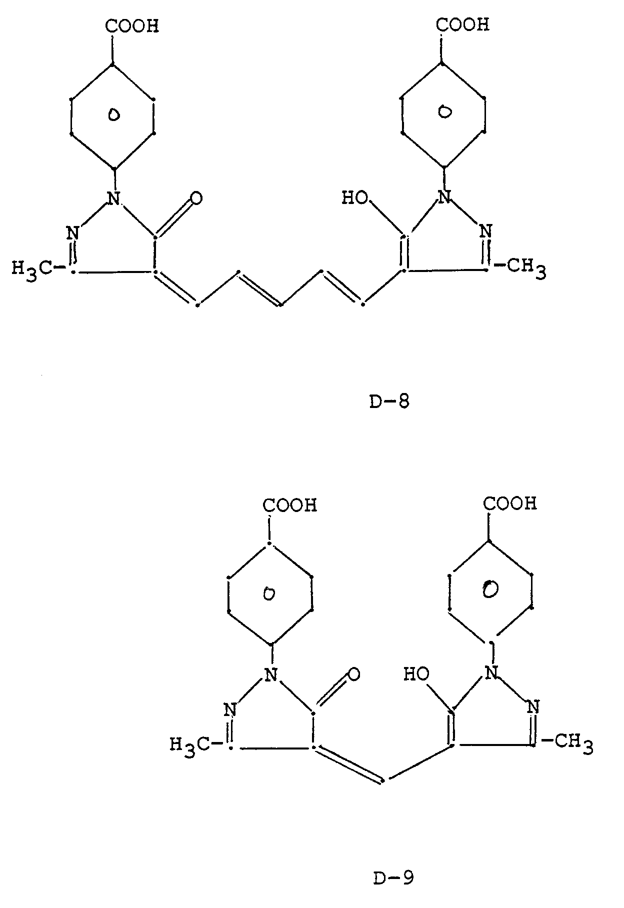

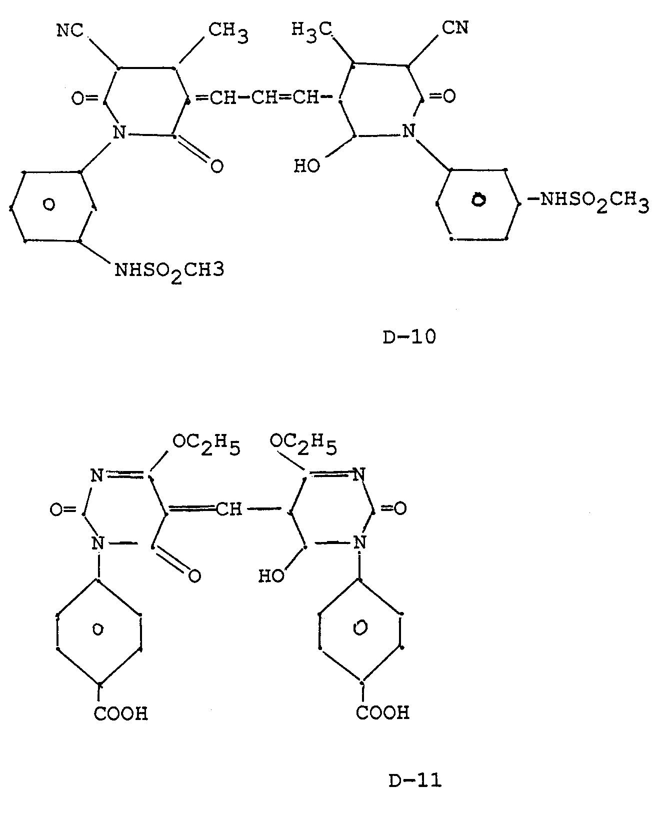

### - merocyanine dyes

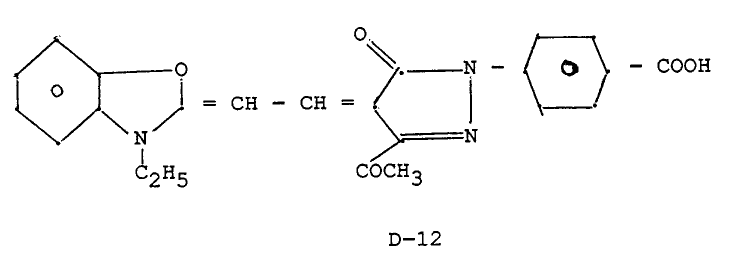

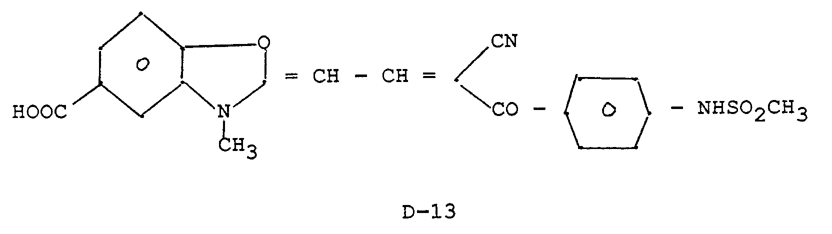

Since these non-diffusable dyes are water-insoluble they are preferably incorporated in the sublayer in the form of a dispersion. In principle a mixture of more than one dye can be used but normally one single dye will be sufficient. The concentration of the dye in the sublayer preferably ranges from 0.01 to 4.0 mmole per m².

The spectrum of the chosen dye must match with the emission wavelenght of the laser or light-emitting diode used for recording the screened data on the photographic film. In the case of exposure by an Ar ion laser the yellow dyes D-1 and D-7 are preferred. In case of the preferred embodiment of the present invention wherein a HeNe laser is used the oxonol dye D-8 is preferred.

Apart from the sublayer described the photographic material used in accordance with the present invention further comprises at least one photosensitive silver halide emulsion layer, and optionally a protective layer and one or more backing layers. In principle, the halide composition of the silver halide emulsions incorporated in the photosensitive emulsion layer(s) is not specifically limited and may be any composition selected from silver chloride, silver bromide, silver iodide, silver chlorobromide, silver bromoiodide, and silver chlorobromoiodide. However, since the sensitivity of the material must comply with the laser energy output of up-to-date image-setters the emulsion is preferably a chlorobromide emulsion, having a chloride content preferably ranging between 70 and 100 mole %, a bromide content preferably ranging between 0 and 30 mole %, and containing only minor amounts of iodide.

The formation of the silver halide grains itself occurs according to well-known conventional techniques. They can be prepared by mixing the halide and silver solutions in partially or fully controlled conditions of temperature, concentrations, sequence of addition, and rates of addition. The silver halide can be precipitated according to the single-jet method, the double-jet method, or the conversion method. The resulting silver halide particles may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms. The silver halide grains may have a multilayered grain structure. According to a simple embodiment the grains may comprise a core and a shell, which may have different halide compositions and/or may have undergone different modifications such as the addition of dopes. Besides having a differently composed core and shell the silver halide grains may also comprise different phases inbetween.

The average size of the silver halide grains may range from 0.05 to 1.0 micron, preferably from 0.2 to 0.5 micron. The size distribution of the silver halide particles of the photographic emulsion can be homodisperse or heterodisperse. A homodisperse size distribution is obtained when 95% of the grains have a size that does not deviate more than 30% from the average grain size.

The silver halide emulsion can be chemically ripened as described i.a. in "Chimie et Physique Photographique" by P. Glafkidès, in "Photographic Emulsion Chemistry" by G.F. Duffin, in "Making and Coating Photographic Emulsion" by V.L. Zelikman et al, and in "Die Grundlagen der Photographischen Prozesse mit Silberhalogeniden" edited by H. Frieser and published by Akademische Verlagsgesellschaft (1968). As described in said literature chemical sensitization can be carried out by effecting the ripening in the presence of small amounts of compounds containing sulphur e.g. thiosulphate, thiocyanate, thioureas, sulphites, mercapto compounds, and rhodamines. The emulsions can be sensitized also by means of gold-sulphur ripeners or by means of reductors e.g. tin compounds as described in GB 789,823, amines, hydrazine derivatives, formamidine-sulphinic acids, and silane compounds. In a preferred embodiment conventional gold-sulphur ripening agents are used.

The silver halide emulsion(s) can be appropriately spectrally sensitized, according to the emission wavelenght of the laser source used for the exposure, with methine dyes such as those described by F.M. Hamer in "The Cyanine Dyes and Related Compounds", 1964, John Wiley & Sons. Dyes that can be used for the purpose of spectral sensitization include cyanine dyes, merocyanine dyes, complex cyanine dyes, complex merocyanine dyes, hemicyanine dyes, styryl dyes and hemioxonol dyes. Particularly valuable dyes are those belonging to the cyanine dyes, merocyanine dyes and complex merocyanine dyes.

The silver halide emulsion for use in accordance with the present invention may comprise compounds preventing the formation of fog or stabilizing the photographic characteristics during the production or storage of photographic elements or during the photographic treatment thereof. Many known compounds can be added as fog-inhibiting agent or stabilizer to the silver halide emulsion. Suitable examples are i.a. the heterocyclic nitrogen-containing compounds such as benzothiazolium salts, nitroimidazoles, nitrobenzimidazoles, chlorobenzimidazoles, bromobenzimidazoles, mercaptothiazoles, mercaptobenzothiazoles, mercaptobenzimidazoles, mercaptothiadiazoles, aminotriazoles, benzotriazoles (preferably 5-methyl-benzotriazole), nitrobenzotriazoles, mercaptotetrazoles, in particular 1-phenyl-5-mercapto-tetrazole, mercaptopyrimidines, mercaptotriazines, benzothiazoline-2-thione, oxazoline-thione, triazaindenes, tetrazaindenes and pentazaindenes, especially those described by Birr in Z. Wiss. Phot. 47 (1952), pages 2-58, triazolopyrimidines such as those described in GB 1,203,757, GB 1,209,146, JA-Appl. 75-39537, and GB 1,500,278, and 7-hydroxy-s-triazolo-[1,5-a]-pyrimidines as described in US 4,727,017, and other compounds such as benzenethiosulphonic acid, benzenethiosulphinic acid and benzenethiosulphonic acid amide. Other compounds that can be used as fog-inhibiting compounds are metal salts such as e.g. mercury or cadmium salts and the compounds described in Research Disclosure N° 17643 (1978), Chapter VI.

The fog-inhibiting agents or stabilizers can be added to the silver halide emulsion prior to, during, or after the ripening thereof and mixtures of two or more of these compounds can be used.

Besides the silver halide another essential component of a light-sensitive emulsion layer is the binder. The binder is a hydrophilic colloid, preferably gelatin. This gelatin can be lime-treated or acid-treated gelatin. The preparation of such gelatin types has been described in e.g. "The Science and Technology of Gelatin", edited by A.G. Ward and A. Courts, Academic Press 1977, page 295 and next pages. The gelatin can also be an enzyme-treated gelatin as described in Bull. Soc. Sci. Phot. Japan, N° 16, page 30 (1966). The gelatin can contain calcium or can be substantially free of calcium.

Gelatin can, however, be replaced in part or integrallly by synthetic, semi-synthetic, or natural polymers. Synthetic substitutes for gelatin are e.g. polyvinyl alcohol, poly-N-vinyl pyrrolidone, polyvinyl imidazole, polyvinyl pyrazole, polyacrylamide, polyacrylic acid, and derivatives thereof, in particular copolymers thereof. Natural substitutes for gelatin are e.g. other proteins such as zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives such as hydroxyalkyl cellulose, carboxymethyl cellulose, phtaloyl cellulose, and cellulose sulphates.

The binders of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts as disclosed in US 4,063,952.

The photographic emulsion can be coated on a support by means of any of the conventional coating techniques, e.g. dip coating, air knife coating, extrusion coating, slide hopper coating and curtain coating.

The photographic material may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Such surface-active agents can be used for various purposes e.g. as coating aids, as compounds preventing electric charges, as compounds improving slidability, as compounds facilitating dispersive emulsification, as compounds preventing or reducing adhesion, and as compounds improving the photographic characteristics e.g higher contrast, sensitization, and development acceleration.

The photographic element of the present invention may further comprise various other additives such as e.g. compounds improving the dimensional stability of the photographic element, UV-absorbers, spacing agents and plasticizers.

Suitable additives for improving the dimensional stability of the photographic element are i.a. dispersions of a water-soluble or hardly soluble synthetic polymer e.g. polymers of alkyl(meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

Beside the light sensitive emulsion layer(s) and the sublayer specifically used in this invention the photographic material can contain several other non-light sensitive layers, e.g. an anti-stress top layer and one or more backing layers.

The support of the photographic material may be opaque or transparent, e.g. a paper support or resin support. When a paper support is used preference is given to one coated at one or both sides with an Alpha-olefin polymer, e.g. a polyethylene layer which optionally contains an anti-halation dye or pigment. In a preferred embodiment however of this invention a transparent organic resin support is used e.g. cellulose nitrate film, cellulose acetate film, polyvinylacetal film, polystyrene film, polyethylene terephthalate film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a subbing layer.

The processing cycle of the exposed photographic materials conventionally includes a development step, a fixing step, a washing step and a drying step. Since in the practice of this invention the development is of the black-and-white type such well-known substances like 1,4-dihydroxy benzene compounds such as hydroquinone, chlorohydroquinone, bromohydroquinone, toluhydroquinone, morpholinemethyl hydroquinone and sulfohydroquinone can be chosen as developing agent. Apart from the main developing agent an auxiliary developing agent can be used. Typical auxiliary developing agents include 3-pyrazolidone developing agents, e.g. 1-phenyl-3-pyrazolidone, 1-phenyl-4, 4-dimethyl-3-pyrazolidone, 1-phenyl-4-methyl-4'-hydroxymethyl-3-pyrazolidone, and N-methyl-p-aminophenol sulphate.

The alkaline pH values of the developing solutions are preferably established by means of conventional buffering agents like phosphate buffers, carbonate buffers and borax buffers. Other adjuvants well known to those skilled in the art may be added to the developer liquid used in accordance of the present invention. A survey of conventional developer addenda is given by Grant Haist in "Modern Photographic Processing" - John Wiley ans Sons - New York (1979) p. 220-224. Examples of such addenda include complexing agents for calcium and magnesium ions, present in hard water, e.g. ethylene diamine tetraacetic acid and analogues compounds. Further can be present anti-foaming agents, surface-active agents, biocides, thickening agents like polystyrene sulphonate and antioxidants like benzoate and cyclodextrine. The developing liquid can contain so-called anti-sludge agents in order to reduce dirt streaks on developed photographic material. Finally the solution can contain development accelerating agents like polyalkyleneoxides and hardening agents including latent hardeners.

In a preferred embodiment the developer is a typical graphic arts Rapid Access developer containing hydroquinone-Phenidone, carbonate buffer, sulphite and bromide ions, and a development fog restrainer. Typically the development temperature is about 35 °C and the develoment time is about 30 seconds.

The fixer is preferably a conventional ammonium thiosulphate or sodium thiosulphate containing fixer.

The exposure source used for writing the screened data of the original on the photographic material can be any laser, e.g. a Ar ion laser, a HeNe laser, a laserdiode, or light-emitting diode (LED) source. However, in a preferred embodiment the frequency-modulated screened original is recorded onto the photographic material used in accordance with the invention by means of a HeNe laser emitting at 632 nm in the red spectral region. As a consequence a red sensitized photographic material is used in this embodiment. An image-setting apparatus, equipped with such a HeNe laser, is, for instance, the SELECTSET 7000 image-setter, marketed by Miles Inc., Agfa division, Wilmington, MA, USA. When Agfa's CristalRaster technology is implemented micro dot sizes can be recorded of 21 µm when operating at 2400 dpi (dots per inch) and of 14 µm when operating at 3600 dpi. A superb quality can be obtained in the halftone image and in the final print. No subject Moiré, colour Moiré or disturbing noise occurs. There are no colour casts ("rainbows") in neutral printed areas. The technique enables printing with more than four inks ("Hi-Fi" colour). Very fine details can be rendered. No rosette structures appear. Smooth image areas are faithfully reproduced.

The invention is illustrated by the following examples without however being limited thereto.

### EXAMPLES

### - preparation of photographic samples

Onto a transparent subbed polyethylene terephthalate (PET) support of 100 µm thickness were coated following layers :

### - on the one side :

### (a) backing layer 1

To 1 l of a solution containing 28 g of gelatin were added 540 ml of a 15 % dispersion of conductive polymer co(tetraallyloxyethane / methacrylate / methacrylic acid potassium salt). This solution was coated on the PET support at a gelatin coverage of 0.56 g/m².

### (b) backing layer 2

To 1.8 l of a solution containing 103 g of gelatin 40 ml of a 11.6 % solution of a dye having formula I (see below) was added in order to enhance the visual difference between back side and emulsion side of the final photographic material. Furtheron 25 ml of a 10 % aqueous solution of an anti-halation dye having formula II (see below) was added. After the addition of conventional surfactants, silica and a matting agent this coating solution was applied on top of the first backing layer at a gelatin coverage of 2.12 g/m².

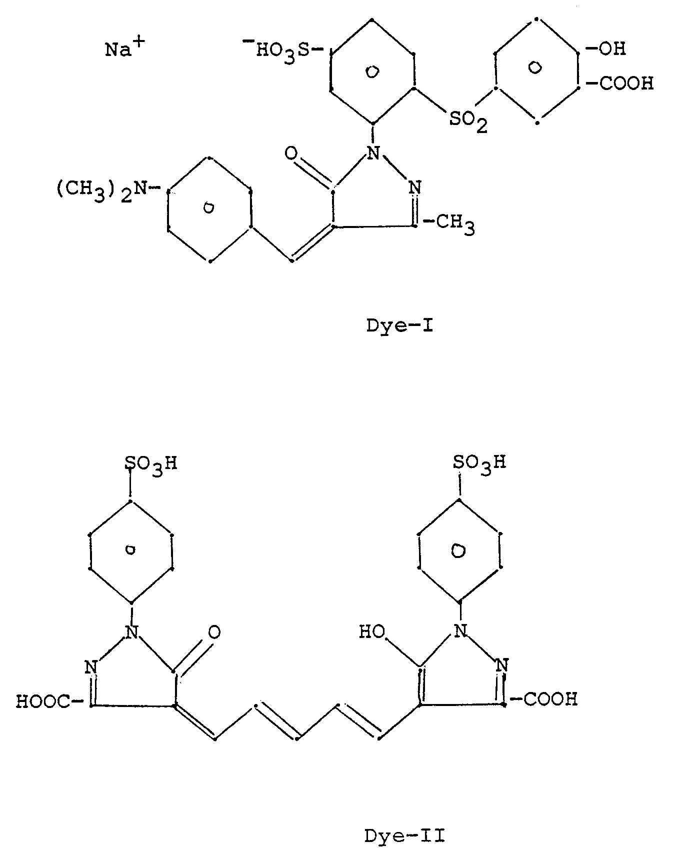

### - on the other side :

### (c) sublayer in accordance with the invention

To 1 l of a 2.4 % gelatinous solution a dye dispersion was added in three different amounts (see table 1) . This dispersion essentially contained 1.3 % of a blue dye corresponding to formula D-8 (see description) and 3 % of a yellow dye corresponding to formula D-9, 10 % of gelatin, a surfactant and a biocide. From these solutions sublayers were coated at a gelatin coverage of 1.2 g/m². A fourth sample serving as reference contained no sublayer (c).

In this particular example only the incorporation of blue dye D-8 belongs to the scope of the present invention since yellow dye D-9 in not absorptive for HeNe red laser radiation (see photographic evaluation furtheron) and merely serves for a better visual differentiation between back side and emulsion side under dark room conditions.

### (d) photosensitive emulsion layer

A high contrast emulsion was prepared by a double jet, containing 0.4 mole % of iodide, 16 mole % of bromide and 83.4 mole % of chloride, and having an average grain size of 0.3 µm. This emulsion was chemically sensitized with conventional sulphur and gold ripening agents. To 1 kg of this emulsion containing 1.10 moles of silver halide were added 20 ml of a 5 % solution of stabilizer 4-hydroxy-6-methyl-1,3,3a,7-tetraazaindene, 12 ml of a 1 % solution of antifoggant 4-carboxy-(1-phenyl-5-mercaptotetrazole) and 80 ml of a 0.4 % aqueous solution of a red spectral sensitizer having formula SS-1 (see below). By means of a diluted bromide solution the pAg was adjusted to a value corresponding to a silver potential of 130 mV. After addition of a latex and a surfactant the solution was coated on top of the sublayers at a gelatin coverage of 3.15 g/m² and a silver coverage of 7.0 g/m², expressed as AgNO₃.

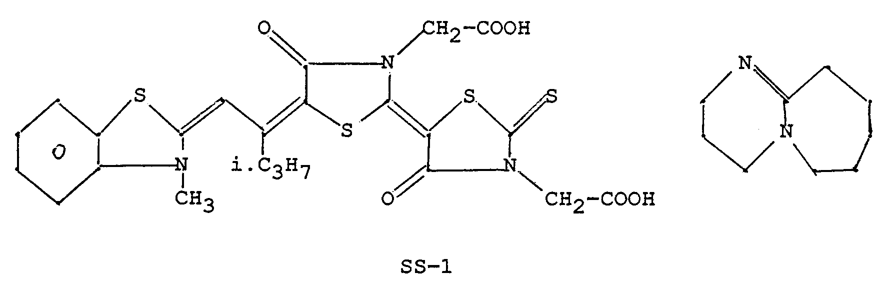

### (e) protective layer

The four photographic samples were overcoated with a protective layer containing 1 g of gelatin/m², minor amounts of carboxy-Phenidone and hydroquinone, and suitable amounts of a matting agent, surfactants and a formaldehyde hardener.

### - photographic evaluation

By an image-setter equipped with a HeNe laser a digitally generated frequency modulated tone scale pattern ranging from 0 % screen dot to 100 % screen dot was exposed with varying intensities onto the different photographic samples prepared (image-setter SELECTSET 7000, equipped with a HeNe laser, marketed by Miles Inc., Agfa Division ; screening technology : CristalRaster, registered trade mark by Agfa, at 2400 dpi).

The exposed samples were processed in an automatic processor. The rapid access developing solution essentially contained Phenidone and hydroquinone as developers, a carbonate buffer, sulphite and bromide ions, and 1-phenyl-5-mercaptotetrazole as restrainer. Subsequently the samples were fixed in a conventional ammonium thiosulphate containing fixer, rinsed and dried.

For the different samples the exposure intensity was determined at which the original 50 % dot was correctly reproduced as a 50 % dot. At this intensity the reproduced density of the 100 % original dot, defined as the practical maximum density, was also measured. This maximum density is related to the exposure latitude achievable on copying the formed image onto a printing plate (the higher,the better).

Furtheron the reproduced density of the 98 % original dot was measured at those exposure intensities were a maximum density of 4.5 for each different sample was reached. This value gives an idea about the sharpness of the film ; the lower this density the better the smallest image details are rendered by the photographic material.

The results are summarized in table 1.

**TABLE 1**

| Sample | g/l dye dispersion | pract. Dmax at correct 50 % dot | density of 98 % dot at pract. Dmax 4.5 |
|---|---|---|---|
| 1 | 50 | 4.20 | 1.82 |
| 2 | 100 | 4.60 | 1.76 |
| 3 | 156 | 4.95 | 1.70 |
| 4 | no sublayer | 4.10 | 1.85 |

These data show that the reference sample 4 has a lower practical maximum density at faithful 50 % dot reproduction compared to the samples prepared in accordance with the invention. Also the measured density of the reproduced 98 % dot is highest for the reference sample. This indicates that the reference sample is less sharp than the samples prepared in connection with the invention.

## Claims

1. Method for the formation of a halftone image, said method comprising the steps of screening an original by a frequency modulation screening technique, recording the obtained screened data by means of a laser or a light-emitting diode on a photographic material comprising a support and at least one silver halide emulsion layer, and developing said exposed photographic material, characterized in that said photographic material further comprises a non-light sensitive sublayer which is positioned between said support and said at least one emulsion layer, and which contains a dye absorptive for the radiation of said laser or light-emitting diode.

2. Method according to claim 1 wherein said dye is a non-diffusible dye.

3. Method according to claim 2 wherein said laser is a HeNe laser or red emitting laserdiode and said dye is an oxonol dye corresponding to following chemical formula :

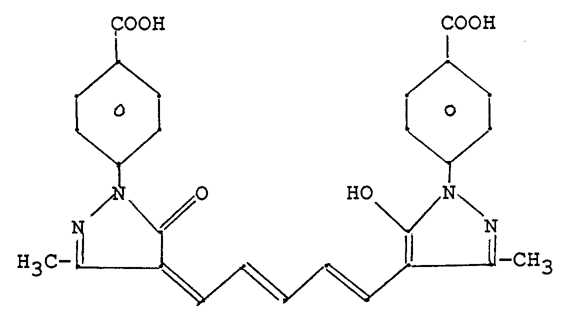

4. Method according to any of claims 1 to 3 wherein said dye is present in said sublayer in a concentration between 0.01 mmole/m² and 4.0 mmole/m².

5. Method according to any of steps 1 to 4 wherein said frequency modulation screening technique proceeds according to following steps :
- selecting an unprocessed image pixel according to a space filling deterministic fractal curve or a randomized space filling curve and processing said unprocessed image pixel as follows:
- determining from the tone value of said unprocessed image pixel a reproduction value to be used for recording said image pixel on a recording medium e.g. a photographic film or lithographic printing plate precursor,
- calculating an error value on the basis of the difference between said tone value of said unprocessed image pixel and said reproduction value, said unprocessed image pixel thereby becoming a processed image pixel,
- adding said error value to the tone value of an unprocessed image pixel and replacing said tone value with the resulting sum or alternatively distributing said error value over two or more unprocessed image pixels by replacing the tone value of each of said unprocessed image pixels to which said error value will be distributed by the sum of the tone value of the unprocessed image pixel and part of said error,
- repeating the above steps until all image pixels are processed.
